# EUROPEAN PATENT SPECIFICATION

(11) **EP 0 243 707 B1**
(45) Date of publication and mention of the grant of the patent: **24.03.1993**
(21) Application number: 87104806.2
(22) Date of filing: 01.04.1987
(51) Int. Cl.: H01L 21/02, H01L 21/90, H01L 23/52

(54) **A method of establishing a conductive via path**
Verfahren zur Herstellung einer Verbindungsleitung
Procédé pour la formation d'une ligne de jonction conductrice

(30) Priority: 30.04.1986 US 857275
(43) Date of publication of application: 04.11.1987
(73) Proprietor: International Business Machines Corporation, Armonk, N.Y. 10504 (US)
(72) Inventor: Flagello, Donis George, Ridgefield Connecticut 06877 (US); Wilczynski, Janusz Stanislaw, Ossining New York 10562 (US); Witman, David Frank, Pleasantville New York 10570 (US)
(74) Representative: Barth, Carl Otto

(56) References cited:
- EP-A- 0 103 879
- EP-A- 0 127 020
- DE-A- 3 400 295
- DE-A- 3 407 799
- US-A- 4 640 010
- IBM TECHNICAL DISCLOSURE BULLETIN vol. 23, no. 10, March 1981, pages 4751,4752, New York, US; W.D. Grobman: "Multilayer packaging using resist layers"

## Description

This invention is directed to a method of establishing a conductive via path between spaced interlevel conductors as may be used in semiconductor device packaging. Such multiple level wiring patterns may exist at the chip level or on a chip carrier having multilevel conductors and interconnections from one level to another.

An example of a prior art multilevel conductor interconnection system is illustrated in IBM TDB Vol. 23, No. 10, pp. 4751-4752 (March 1981).

As disclosed therein, on a substrate surface circuit elements are placed. The multilevel structure is then sequentially built up by providing a resist layer followed by patterning of the recess for contact holes (vias). The holes are then created and the next layer, a first metal, is then patterned. Alignment between the vias and the metal layer is critical.

Processing continues by applying a second resist layer and patterning that layer to provide for additional vias. These vias must align with the previously defined vias in the lower resist layer. Applying and patterning of a second metal layer proceeds and then the process continues to define a third resist layer. Consequently, as illustrated in this typical prior art scheme, each resist layer is separately patterned. Additionally, each metal layer lying on top of a respective resist layer must be separately patterned. Given the number of patterning steps, production costs for such a device are high. Moreover, a common source of defects which contributes to yield losses deals with the misalignment between vias at various levels. Thus, for example, as illustrated in the TDB, the via existing between the top metal and one of the circuit elements comprises three segments. A misalignment in the patterning to create the holes for any of those segments can result in defective formation of a via. In extreme cases of misalignment an internal short-circuit may result, rendering the entire package unusable.

While the problem of creating aligned vias with a minimum number of steps has been defined relative to multilayer packaging for circuit elements, the same problem exists relative to internal metallization of the device elements themselves. That is, separate metallization for each individual stage. To date, only by exact pattern alignment can yield losses be minimized. Consequently, techniques exist to increase production capacity, but the art has been unable to provide a solution which provides the required accuracy and, at the same time, reduces overall manufacturing costs.

Contemporary packaging schemes employ four discrete levels of metal and seven masking steps when interconnections between levels are required. Consequently, there exists a need in the technology to find a scheme which reduces the number of masking steps while maintaining accuracy.

A second problem encountered with prior art techniques of sequential patterning and etching is that of contamination which may exist at any individual level. In order to remove contaminants which may be trapped within the package as the vias and metal layers are successively defined, elaborate precautions are employed to reduce the possibility of entrapment of contaminants. This in turn contributes to the overall increase in manufacturing cost.

The European Patent Application EP-A-0 127 020 is the nearest priort art. It relates to a method for the fabrication of a multi-layer semiconductor device. Metal interconnections between metal layers of this device, being embedded by insulating films, are formed by defining a mask on top of the structure and etching through the insulating films and metal layers in one etch step. After this etch step an aluminum layer is deposited on the surface of the device and the inner surfaces of the etched holes, such that an interconnection between said metal layers and the aluminum surface metallization is formed.

Given the deficiencies in the prior art, it is an object of this invention to define a scheme for providing connections between two or more metal levels that reduces the number of processing steps, and which eliminates alignment errors, whether random or progressive, in the definition of multilevel vias.

Another object of this invention is to provide a unique via construction which eliminates alignment and contamination problems in a multilayer package.

The invention as claimed is intended to remedy the drawbacks hitherto encountered. The above objects of this invention are attained by a method of establishing a conductive via path between spaced interlevel conductors wherein upper level metal circuitry above a first metal line is provided with annular paths such that the interconnections are defined in a single via establishment step. In accordance with this method, the first level having a pattern of conductive material is laid down on a substrate. Then, successive alternating layers of insulator or dielectric, and a layer of conductive material, are built up. The only patterning is of the conductive material. Each pattern of conductive material has annular or path locations where interconnections may be opened between levels. But when the final top metal is applied (or at some intermediate stage), the package is patterned to create via paths by opening appropriate locations through the dielectric layers to an appropriate metal layer. Via paths are then filled with a conductive material.

In accordance with this technique, patterning at the resist level to create via openings for that level per se are eliminated. Consequently, the number of masking and opening steps is reduced.

Because the via paths are opened in one step, self-alignment of the via path takes place. Contaminants which may exist at a particular level are eliminated since the packaging is completed at the time the via paths are opened.

Additionally, filling of the via paths takes place in a manner which prevents shorts and guarantees electrical continuity in the via path. That is, in prior techniques with the via paths opened on a layer-by-layer basis, the via path comprises a series of stacked trapezoids. The propensity of having incomplete filling at any individual level exists. Moreover, the problem of escapement of conductive material into a particular level remains if alignment is not achieved. In accordance with this invention, the simultaneous opening of a via path results in a passage which progressively decreases from top metal down to the metal layer to be contacted. Thus, complete filling is achieved expeditiously without the problems inherent in the prior art technique.

This invention will be explained in greater detail below with reference to drawings which illustrate preferred embodiments and in which:
Figure 1A is a schematic cross-section of a multi-level structure prior to final etching;
Figure 1B illustrates a cross-section of the structure of Figure 1A following etch;
Figure 1C illustrates a cross-section of the structure of Fig. 1B following via plating;
Figure 2 is a top view looking down onto the second level metal, through the intermediate dielectric, and then down to the first level metal; and
Figure 3 is a cut away perspective illustrating interconnections between three levels of metallization in accordance with the present invention.

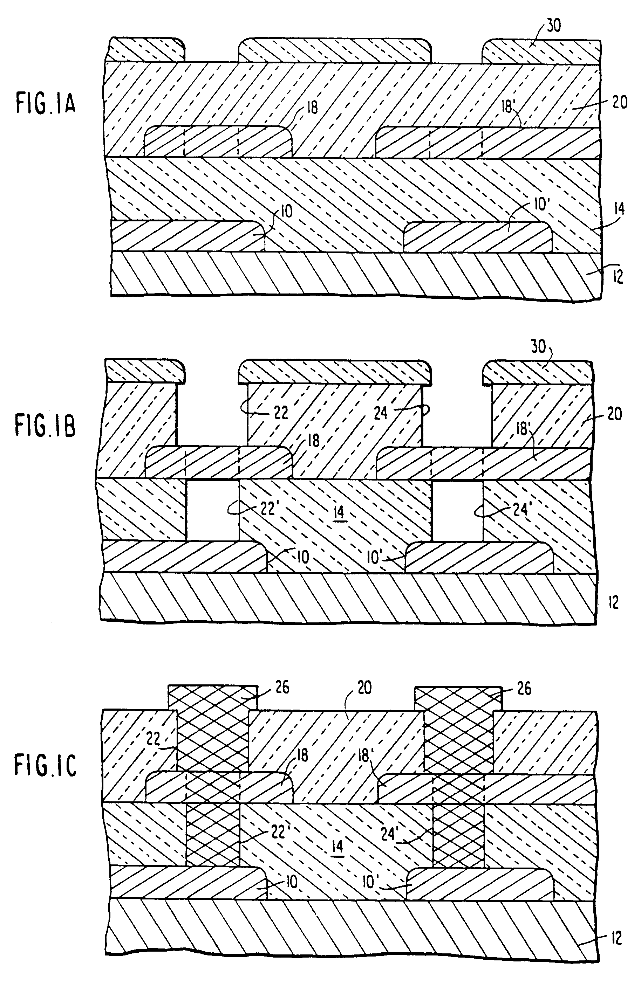

Referring now to Figure 1A, a cross sectional view of the packaging structure prior to final etch is illustrated. Onto a substrate 12, a first metal layer 10,10ʹ is deposited. This metal layer is defined in a conventional manner, for example, by lift-off techniques which are well known in the art. On top of this first metal layer, a first dielectric layer 14 is deposited.

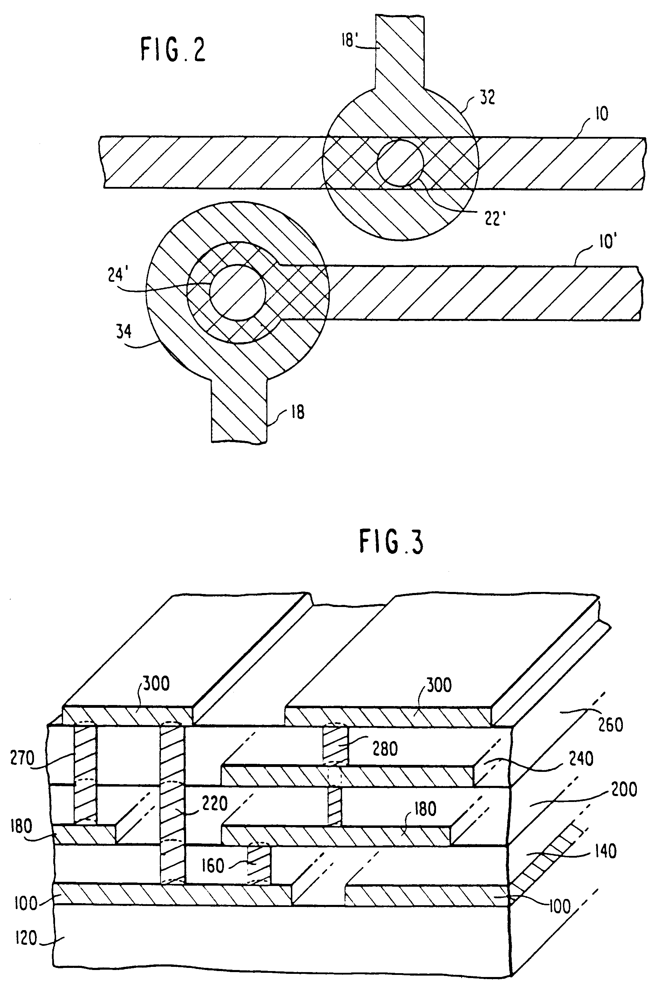

A second metal layer 18,18ʹ is deposited over the first dielectric layer 14. The second metal layer is patterned using conventional techniques and includes annular paths or enlarged regions where contacts may be required to the first metal layer. Such are illustrated in Figure 2.

A second layer of dielectric material 20 is then deposited over the second metal layer. It should be noted that, in accordance with this invention, there is no patterning of either the first or second dielectric layers 14 and 18.

Processing continues until all metal layers have been defined. That is, while Figure 1A shows two such metal layers, it is to be understood that the invention is not limited to such structure; any number of metal layers may be employed. When the final number of metal layers is determined, an etch mask 30 is placed on the top surface. Figure 1A illustrates the condition of the mask following exposure and development to produce the pattern for the vias. This is followed by etching, using wet or dry techniques through the top dielectric layer 20, second metal layer 18 (18ʹ), the first dielectric layer 14 and stopping at the first metal layer 10 (10ʹ).

Figure 1B illustrates a cross section of such a structure following the described etch step. As is illustrated in Figure 1B, two self-aligned vias 22 (22ʹ) and 24 (24ʹ) are defined. The vias progressively decrease in width. Typically, a 2 µm stepwise decrease from one level to the other occurs. Thus, if the via 22 has a diameter of approximately 10 µm through the second dielectric layer 20, the diameter of section 22ʹ of the via through the first dielectric layer 14 would be in the order of 8 µm.

Figure 1C illustrates stripping of the etch mask and final plating of the via opening. Removal of the resist layer 30 is optional.

The via openings 22 (22ʹ) and 24 (24ʹ) as illustrated in Figure 1C are filled with a conductor such as a solder paste, plated copper or gold. In the case of the use of solder paste, the conductor may be applied by squeezing into the via openings or by other manual techniques. Additionally, sputter filling could take place. The device may be finished by Chem-mech polishing to define plated vias having terminals 26 and 28 as illustrated in Figure 1C.

Referring now to Figure 2, a top level view showing the two levels of metal (10,10ʹ and 18,18ʹ) with annular regions 32 and 34 in accordance with this invention is illustrated. Metal line 10 is a continuous line existing in the first metal level whereas metal line 10ʹ represents a terminal. The second level metal pattern 18 and 18ʹ end with annular enlarged regions 32 and 34. Those annular regions substantially overlap the first level metal. The via opening existing through the first dielectric layer is illustrated terminating at the first metal level.

Figure 3 is a schematic perspective view illustrating various interconnect techniques employing the method of this invention. As illustrated in Figure 3, three layers of metallization are employed plus the top contact layer 300. The completed device is built on the substrate 120 and comprises metal pattern layers 100, 180 and 240. Between each of the metal layers is a dielectric layer 140, 200 and 260. It is appreciated that the layers fill all spaces between adjacent metallization layers. For purposes of illustration the cross-hatching has been eliminated.

Figure 3 illustrates various via connections between the metallization layers. For example, via 270 extends from top metal 300 through dielectric layers 200 and 260 to contact the top surface of the second metal layer 180. Via 220 extends from top metal layer 300 through three dielectric layers 140, 200, and 260 to terminate on the first metal layer 100. A connection from one metal layer to another is illustrated as via 160. A via extending from the top metal layer 300 through intermediate metal layer 240 down to the intermediate metal layer 180 is illustrated as via 280. In all cases, the vias are self-aligned given the processing of this invention. For purposes of explanation, the metal filling of each of the openings has been deleted from this drawing.

In accordance with this invention improvements in alignment occur in the formation of vias 220, 270 and 280. Via 160 extending between adjacent layers would be created using conventional techniques.

The choice of material for metal layers 100, 180 and 240 is as typically, in the case of a chip carrier device, copper, aluminum or gold. Use of this invention at the chip level would lay down the metal by evaporation and sputtering techniques and employ a lower resistance metal. Typically, the metal lines at a chip level would be an aluminum-copper-silicon composite having approximately 4 to 5% copper and approximately 1% silicon. The dielectric layers in the case use of this invention in a packaging context would be polyamides, silicon-containing polyimides or novolac resins. The etching to create the via openings could use an oxygen plasma if the dry process is selected. However, for opening vias for two levels, i.e. 160 in Figure 3, a wet process, known in the art, can be employed.

At the chip level, the insulating material would typically be silicon dioxide. A suitable etchant for the oxide would be CF₄.

As can be appreciated from Figure 3, increased metallization density occurs using this technique since the vias are inherently self-aligned. Consequently, in addition to eliminating masking steps and removing the critical alignment problem when RIE is used as the etch step of choice for sequential processing, this invention allows for compactness in ultimate processing design.

Thus, it is apparent that the system in accordance with this invention may be used at the packaging or multilayer ceramic level as well as the chip level and is generally applicable in the construction of structures having multiple levels of metal and insulator.

## Claims

1. A method of forming a conductive via path between spaced conductor levels comprising the steps of:
defining a first level conductor (10) formed of a pattern of a first conductive material;
applying a first dielectric layer (14) embedding said first level conductor;
defining a second level conductor (18) on said first dielectric layer, said second level conductor being formed of a pattern of a second conductive material and comprising at least one annular area (32) having a via opening, said annular area overlapping said first level conductor;
applying a second dielectric layer (20) embedding said second level conductor;
defining a resist pattern (30) on said second dielectric layer;
etching a via path (22,22') through said second dielectric layer (20), through said via opening in said annular area (32) and through said first dielectric layer (14), using said resist pattern as a mask, said via path terminating at said first level conductor; and
filling said via path (22,22') with a conductive material.

2. The method of Claim 1 further comprising the steps of, prior to the step of defining a second level conductor, defining an intermediate level conductor formed of a pattern of conductive material, on said first dielectric layer and applying an intermediate dielectric layer embedding said intermediate level conductor, and wherein said step of etching a via path includes etching said intermediate dielectric layer.

3. The method of Claim 1 wherein said first (10) and second (18) level conductors comprise wiring levels of a semiconductor chip carrier.

4. The method of Claim 3, wherein said first (14) and second (20) dielectric layers comprise polyimide.

5. The method of Claim 1, wherein said first (10) and second (18) level conductors comprise wiring interconnections of a semiconductor chip.

6. The method of Claim 1, wherein the step of etching a via path comprises simultaneously etching a plurality of via paths at predetermined spaced locations.

## Patentansprüche

1. Verfahren zum Ausbilden eines Durchgangsleitungspfades zwischen beabstandeten Leiterebenen, welches die folgenden Schritte aufweist:
Festlegen eines Leiters (10) einer ersten Ebene, der von einem Muster aus einem ersten Leitermaterial gebildet ist,
Aufbringen einer ersten dielektrischen Schicht (14), welche den Leiter der ersten Ebene einbettet,
Festlegen eines Leiters (18) einer zweiten Ebene auf der ersten dielektrischen Schicht, wobei der Leiter der zweiten Ebene von einem Muster aus einem zweiten Leitermaterial gebildet ist und zumindest einen ringförmigen Bereich (32) mit einer Durchgangsöffnung besitzt, wobei der ringförmige Bereich den Leiter der ersten Ebene überlappt,
Aufbringen einer zweiten dielektrischen Schicht (20), welche den Leiter der zweiten Ebene einbettet,
Festlegen eines Abdeckmusters (30) auf der zweiten dielektrischen Schicht,
Ätzen eines Durchgangspfades (22, 22') durch die zweite dielektrische Schicht (20), durch die Durchgangsöffnung in dem ringförmigen Bereich (32) und durch die erste dielektrische Schicht (14) unter Verwendung des Abdeckmusters als Maske, wobei der Durchgangspfad an dem Leiter der ersten Ebene endet, und
Auffüllen des Durchgangspfades (22, 22') mit einem leitenden Material.

2. Verfahren nach Anspruch 1, welches des weiteren die Schritte beinhaltet, das vor dem Schritt des Festlegens eines Leiters der zweiten Ebene ein Leiter einer Zwischenebene festgelegt wird, der auf der ersten dielektrischen Schicht aus einem Muster aus Leitermaterial gebildet wird, und eine dielektrische Zwischenschicht aufgebracht wird, welche den Leiter der Zwischenebene einbettet, und bei welchem der Schritt des Ätzens eines Durchgangspfades das Ätzen dieser dielektrischen Zwischenschicht einschließt.

3. Verfahren nach Anspruch 1, bei welchem die Leiter (10) der ersten und die Leiter (18) der zweiten Ebene Verdrahtungsebenen eines Halbleiterchipträgers enthalten.

4. Verfahren nach Anspruch 3, bei welchem die erste (14) und die zweite (20) dielektrische Schicht Polyimid enthalten.

5. Verfahren nach Anspruch 1, bei welchem die Leiter (10) der ersten und die Leiter (18) der zweiten Ebene Verdrahtungsverbindungen eines Halbleiterchips enthalten.

6. Verfahren nach Anspruch 1, bei welchem der Schritt des Ätzens eines Durchgangspfades das gleichzeitige Ätzen einer Mehrzahl von Durchgangspfaden an vorbestimmten, beabstandeten Stellen einschließt.

## Revendications

1. Procédé de formation d'un chemin conductrice de traversée entre des niveaux conducteurs espacés, comprenant les étapes de :
définition d'un conducteur de premier niveau (10) formé d'un arrangement d'une première matière conductrice ;
application d'une première couche diélectrique (14) enrobant ledit conducteur de premier niveau ;
définition d'un conducteur de deuxième niveau (18) sur ladite première couche diélectrique, ledit conducteur de deuxième niveau étant formé d'un arrangement d'une deuxième matière conductrice et comprenant au moins une région annulaire (32) à trou traversant, la dite région annulaire chevauchant ledit conducteur de premier niveau ;
application d'une deuxième couche diélectrique (20) enrobant ledit conducteur de deuxième niveau ;
définition d'un arrangement photosensible (30) sur ladite deuxième couche diélectrique ;
attaque d'un chemin de traversée (22,22') à travers ladite deuxième couche diélectrique(20), à travers ledit trou traversant de ladite région annulaire (32) et à travers ladite première couche diélectrique (14), en utilisant ladite arrangement photosensible comme masque, ledit chemin de traversée se terminant au dit conducteur de premier niveau ; et
remplissage dudit chemin de traversée (22,22') avec une matière conductrice.

2. Procédé suivant la revendication 1,
comprenant en outre les étapes , avant l'étape de définition d'un conducteur de deuxième niveau, de définition d'un conducteur de niveau intermédiaire formé d'un arrangement de matière conductrice sur ladite première couche diélectrique et application d'une couche diélectrique intermédiaire enrobant ledit conducteur de niveau intermédiaire, et dans lequel ladite étape d'attaque d'un chemin de traversée comprend l'attaque de ladite couche diélectrique intermédiaire.

3. Procédé suivant la revendication 1,
dans lequel lesdits conducteurs de premier niveau (10) et de deuxième niveau (18) comprennes des niveaux de câblage d'un support de puce semiconductrice.

4. Procédé suivant la revendication 3,
dans lequel lesdites première (14) et deuxième (20) couches diélectriques comprennes polymide**.**

5. Procédé suivant la revendication 1,
dans lequel lesdits conducteurs de premier niveau (10) et de deuxième niveau (18) comprennes des interconnexions de câblage d'une puce semiconductrice.

6. Procédé suivant la revendication 1,
dans lequel l'étape d'attaque d'un chemin de traversée comprend l'attaque simultanée d'une pluralité de chemins de traversée, à des emplacements espacés prédéterminés.
